# EUROPEAN PATENT APPLICATION

(11) **EP 0 877 330 A2**
(43) Date of publication of application: **11.11.1998**
(21) Application number: 98107929.6
(22) Date of filing: 30.04.1998
(51) Int. Cl.: G06F 17/50

(54) **Circuit verification process for semiconductor devices**

(30) Priority: 09.05.1997 JP 119766/97
(71) Applicant: NEC CORPORATION, Tokyo (JP)
(72) Inventor: Mori, Takehiko, Minato-ku, Tokyo (JP)
(74) Representative: Baronetzky, Klaus, Dipl.-Ing.

(57) **Abstract**

A circuit verification process is disclosed for verifying whether the circuit of a semiconductor device meets specifications for logical operations and also predetermining operation timing requirements, at the time of designing the semiconductor device. An address data macroblock having functions that are expected to be changed more often and a peripheral functional macroblock having general functions are prepared separately from each other. Only, the peripheral functional macroblock is registered in a library. When addresses of address decoders of the address data macroblock are changed, only the address data macroblock are redesigned, and the peripheral functional macroblock is used without being verified.

## Description

### BACKGROUND OF THE INVENTION

### 1. Field of the Invention:

The present invention relates to a circuit verification process for verifying whether the circuit of a semiconductor device meets specifications for logical operations and also predetermining operation timing requirements, at the time of designing the semiconductor device.

### 2. Description of the Related Art:

Conventional circuit verification processes for verifying semiconductor devices have been carried out using a macroblock comprising a plurality of functional blocks as independent unit blocks.

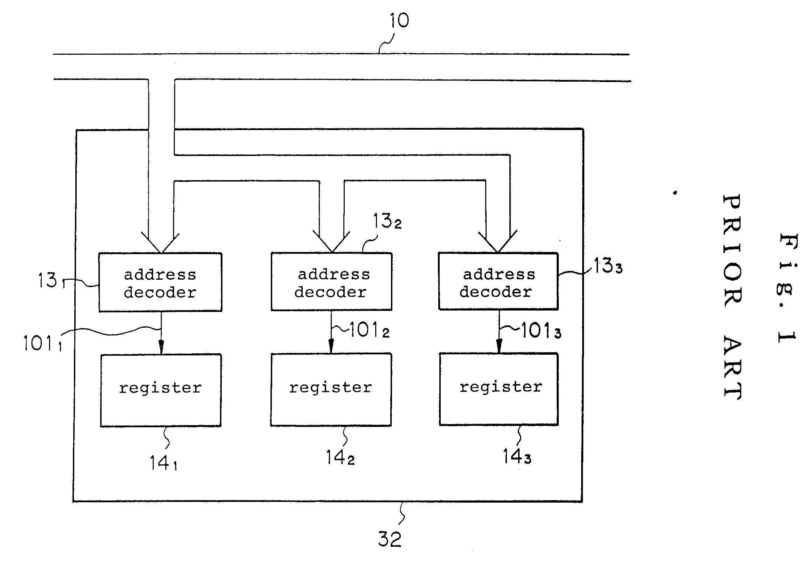

Fig. 1 of the accompanying drawings illustrates in block form a peripheral macroblock 32 to be verified by a conventional circuit verification process for verifying semiconductor devices.

As shown in Fig. 1, the peripheral macroblock 32 comprises a plurality of address decoders 13₁ - 13₃ for activating selection signals 101₁ - 101₃, respectively, when an address specified by an address bus 10 agrees with a predetermined address, and a plurality of registers 14₁ - 14₃ for storing data when the corresponding selection signals 101₁ - 101₃ are activated.

Operation of the peripheral macroblock 32 will be described below with reference to Fig. 1.

When an address specified by the address bus 10 agrees with a predetermined address for the address decoder 13₁, the address decoder 13₁ activates the selection signal 101₁. When the selection signal 101₁ is activated, the register 14₁ stores data. When an address specified by the address bus 10 agrees with predetermined addresses for the other address decoders 13₂, 13₃, the address decoders 13₂, 13₃ and the regiters 14₂, 14₃ also operate in the same manner as described above.

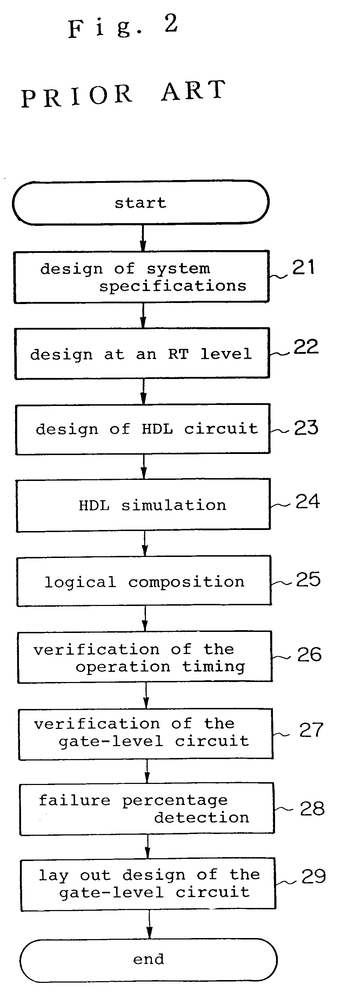

A conventional process for verifying logical operations and operation timing of a semiconductor device will be described below with reference to Fig. 2 of the accompanying drawings.

First, system specifications which define functions, operations, and performance of a macroblock are designed in a step 21. Then, a circuit is designed at an RT (Register Transfer) level in a step 22. Based on the designed RT-level circuit, a circuit is designed using an HDL (Hardware Description Language) in a step 23. Thereafter, logical operations of the HDL circuit designed in the step 23 are verified in a step 24. The HDL circuit designed in the step 23 is converted into a gate-level circuit in a step 25. Then, the gate-level circuit generated in the step 25 is verified to ascertain whether it meets given operation timing requirements in a step 26. The gate-level circuit is also verified for logical operations in a step 27. A failure percentage detection for the gate-level circuit is calculated in a step 28, after which the gate-level circuit is actually laid out on an LSI and interconnected in a step 29.

Macroblocks have addresses which differ according to the products mounted thereon. According to the above conventional verification process, even when only addresses are changed but functions remain unchanged, entire logical operations and operation timing of macroblocks need to be verified. Since the steps 21 - 29 have to be carried out again for each macroblock, the number of steps required for verification is relatively large, and a TAT (Turn Around Time) from the beginning of product development until the delivery of a product to the user is relatively long.

### SUMMARY OF THE INVENTION

It is therefore an object of the present invention to provide a circuit verification process for semiconductor devices composed of a relatively small number of verification steps and allows for a relatively short TAT.

To achieve the above object, there is provided in accordance with the present invention a method of verifying a circuit of a semiconductor device, comprising the steps of preparing a first macroblock having functions that are expected to be changed more often and a second macroblock having general functions, the first macroblock and the second macroblock being separate from each other, registering the second macroblock in a library, redesigning only the first macroblock when the functions that are expected to be changed more often are changed, and using the second macroblock without verifying the same.

The method according to the present invention comprises a smaller number of verification steps and contributes to a shorter TAT than the conventional verification process according to which all the functions of a peripheral macroblock needs to be redesigned and reverified.

The functions that are expected to be changed more often may comprise address decoders each for activating a selection signal when an address designated by an address bus agrees with a predetermined address. Therefore, when addresses of the address decoders are changed, only the address decoders need to be redesigned.

The above and other objects, features, and advantages of the present invention will become apparent from the following description with reference to the accompanying drawings which illustrate an example of the present invention.

### BRIEF DESCRIPTION OF THE DRAWINGS

Fig. 1 is a block diagram of a peripheral macroblock to be verified by a conventional circuit verification process for verifying semiconductor devices;
Fig. 2 is a flowchart of a conventional process for verifying logical operations and operation timing of a semiconductor device; and
Fig. 3 is a block diagram of macroblocks to be verified by a circuit verification process for verifying semiconductor devices according to the present invention.

### DETAILED DESCRIPTION OF THE PREFERRED EMBODIMENT

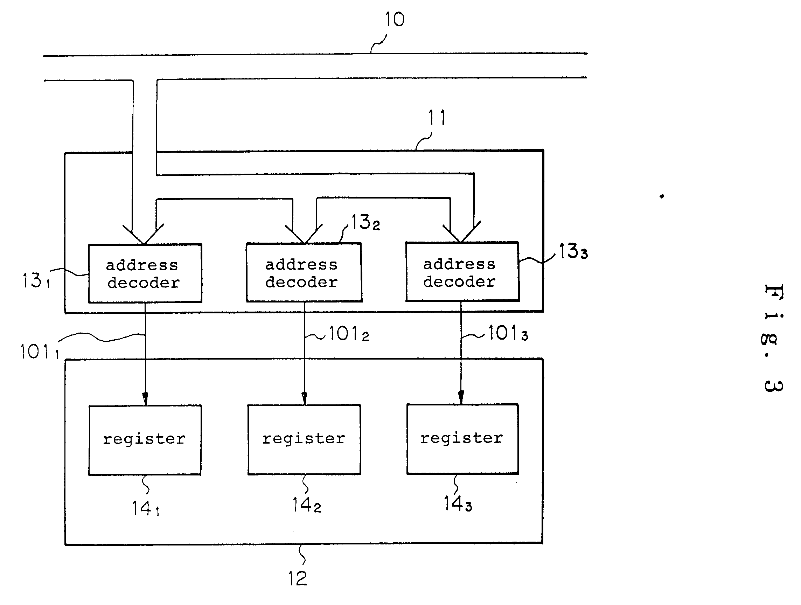

As shown in Fig. 3, macroblocks to be verified by a circuit verification process for verifying semiconductor devices according to the present invention include an independent address data macroblock 11 composed of address decoders 13₁ - 13₃ and a peripheral functional macroblock 12 composed of registers 14₁ - 14₃.

According to the conventional verification process, a macroblock comprises functional blocks as independent unit blocks. According to the present invention, however, functions that are expected to be changed more often and functions that are considered to be general functions are grouped separately from each other, and both groups make up macroblocks, respectively.

After the peripheral functional macroblock 12 is verified for logical operations and operation timing as described with reference to Fig. 2, the peripheral functional macroblock 12 is registered in a library.

The address data macroblock 11 and the peripheral functional macroblock 12 operate essentially in the same manner as the peripheral macroblock 32 shown in Fig. 1. However, when addresses need to be changed, only the address data macroblock 11 is required to be redesigned. Since the verified peripheral functional macroblock 12 is registered in the library, it can be used as it is and is not required to be redesigned.

Consequently, the verification process according to the present invention comprises a smaller number of verification steps and contributes to a shorter TAT than the conventional verification process according to which the peripheral macroblock 32 shown in Fig. 1 needs to be redesigned and reverified.

The verification process according to the present invention has been illustrated as being applied to address decoders as functions that are expected to be changed more often and registers as functions that are considered to be general functions. However, the principles of the present invention are not limited to such a combination, but are also applicable to other functions.

While a preferred embodiment of the present invention has been described using specific terms, such description is for illustrative purposes only, and it is to be understood that changes and variations may be made without departing from the spirit or scope of the following claims.

## Claims

1. A method of verifying a circuit of a semiconductor device, comprising the steps of:
preparing a first macroblock having functions that are expected to be changed more often and a second macroblock having general functions, said first macroblock and said second macroblock being separate from each other;
registering said second macroblock in a library;
redesigning only said first macroblock when said functions that are expected to be changed more often are changed; and
using said second macroblock without verifying the same.

2. A method according to claim 1, wherein said functions that are expected to be changed more often comprise address decoders each for activating a selection signal when an address designated by an address bus agrees with a predetermined address.
